# FASCICULE DE BREVET EUROPEEN

(11) **EP 3 717 679 B1**
(45) Date de publication et mention de la délivrance du brevet: **29.05.2024**
(21) Numéro de dépôt: 18826417.0
(22) Date de dépôt: 27.11.2018
(51) Int. Cl.: C25D 3/56, C25D 5/10, C25D 5/12, C25D 7/00, H05K 3/10, H05K 3/20, G06K 19/077, C25D 5/00, H05K 1/02, H05K 3/24

(54) **CIRCUIT ÉLECTRIQUE, MODULE ÉLECTRONIQUE POUR CARTE À PUCE RÉALISÉ SUR CE CIRCUIT ÉLECTRIQUE ET PROCÉDÉ POUR LA RÉALISATION D'UN TEL CIRCUIT ÉLECTRIQUE**
ELEKTRISCHE SCHALTUNG, ELEKTRONISCHES MODUL FÜR EINE AUF DER ELEKTRISCHEN SCHALTUNG GEFORMTE CHIPKARTE UND VERFAHREN ZUR HERSTELLUNG SOLCH EINER ELEKTRISCHEN SCHALTUNG
ELECTRIC CIRCUIT, ELECTRONIC MODULE FOR A CHIP CARD FORMED ON THE ELECTRIC CIRCUIT, AND METHOD FOR THE PRODUCTION OF SUCH AN ELECTRIC CIRCUIT

(30) Priorité: 28.11.2017 FR 1761324
(43) Date de publication de la demande: 07.10.2020
(73) Titulaire: Linxens Holding, 78200 Mantes-la-Jolie (FR)
(72) Inventeur: NSALAMBI, Hugues, 78820 Juziers (FR); VENON, Florian, 78200 Mantes La Jolie (FR); SANSON, Jérome, 78910 Osmoy (FR); CARDOSO, Guillaume, 78711 Mantes La Ville (FR)
(74) Mandataire: INNOV-GROUP
(86) Numéro de dépôt international: PCT/FR2018/053011
(87) Numéro de publication internationale: WO 2019/106284

(56) Documents cités:
- EP-A1- 2 866 173
- JP-A- S5 544 534
- US-A1- 2017 245 038

## Description

L'invention concerne le domaine des circuits électriques.

Par exemple, des circuits électriques selon l'invention peuvent être des circuits imprimés avec des pistes conductrices et/ou des plages de contact électrique gravées dans une couche conductrice préalablement déposée sur un substrat, ou bien des circuits comprenant une ou plusieurs grilles de connexion chacune constituées d'une feuille de matériau conducteur découpée et co-laminée avec un substrat isolant. De tels circuits électriques sont utilisés par exemple pour la réalisation de contacts pour modules électroniques de carte à puce, d'antennes pour carte à puce, de circuits mixtes comprenant à la fois des contacts et une antenne, etc.

Les cartes à puce ont de multiples usages : cartes de crédit, carte SIM pour téléphones portables, cartes de transport, cartes d'identité, etc. et l'invention présente un intérêt particulier pour la réalisation de circuits imprimés comportant des pistes conductrices et/ou des plages de contact visibles sur le produit fini.

A titre d'illustration, si on prend l'exemple des cartes à puce, celles-ci sont généralement constituées d'un support rigide, par exemple en matière plastique, constituant l'essentiel de la carte, dans lequel est incorporé un module électronique fabriqué séparément. Ce module électronique comporte un circuit imprimé, généralement flexible, muni d'une puce (circuit intégré) et de moyens de connexion de la puce à un dispositif permettant de lire et/ou d'écrire des données dans la puce. Ces moyens de connexion -ou connecteurs- sont par exemple des contacts constitués de pistes métalliques conductrices affleurant sur le module électronique, en surface du support. Outre la nécessité d'avoir une excellente résistance mécanique et une excellente résistance à la corrosion des contacts, ainsi qu'une bonne conduction électrique entre la puce et les contacts d'une part et entre les contacts et un dispositif de lecture/écriture d'autre part, les fabricants de cartes à puce souhaitent assortir la couleur des contacts à la ou les couleurs(s) de la carte. A cet effet, les contacts sont généralement recouverts soit d'une couche d'or, pour obtenir une finition dorée, soit d'une couche d'argent ou de palladium, pour obtenir une finition argentée.

Pour obtenir plus de couleurs, il est possible d'utiliser un procédé tel que décrit dans le document US6259035B1. Ce procédé repose sur l'utilisation de solutions à base d'or, de palladium ou d'argent pour obtenir un plus large spectre de couleurs. Par ailleurs, le document EP2866173A1 décrit un procédé de fabrication d'un circuit électrique correspondant au préambule de la revendication 1. Enfin, le document JPS5544534A décrit un procédé de dépôt dans lequel un alliage de rhodium et de ruthénium est électrodéposé en couche mince sur des contacts électriques afin de former une couche conductrice sans fissures apparentes.

Un but de l'invention est de réaliser des circuits imprimés flexibles comportant des pistes conductrices visibles sur le produit fini, ayant une couleur blanche ou se rapprochant de la couleur blanche (par exemple un éclat métallique tirant sur le blanc), tout en conservant des propriétés électriques et mécaniques appropriées pour leur utilisation dans des modules à contacts pour carte à puce.

A cet effet, il a été conçu selon l'invention un circuit électrique pour la réalisation de modules de cartes à puce, tel que défini par la revendication 1. Ce circuit électrique comprend notamment les dispositions suivantes.

Il comporte un substrat et au moins une piste conductrice. Le substrat est un substrat diélectrique, par exemple de verre-epoxy. Avantageusement, ce substrat est flexible. La piste conductrice est par exemple réalisée par photo-lithogravure. C'est-à-dire en collant et laminant sur le substrat, une couche de matériau conducteur, par exemple de cuivre ou d'un alliage de cuivre, dans laquelle des motifs sont ensuite avantageusement gravés pour réaliser une ou plusieurs pistes ou plages conductrices qui peuvent être utilisées par exemple comme contacts électriques. De manière alternative, les motifs sont découpés dans un feuillet de matériau conducteur, par exemple du cuivre ou un alliage de cuivre, avant de les co-laminer avec un substrat diélectrique (on parle alors de technologie « lead frame » selon la terminologie anglo-saxonne).

La piste conductrice peut également comporter une ou plusieurs couches de métallisation (notamment, de nickel, de nickel-phosphore, ou d'un alliage de cobalt-tungstène, et éventuellement d'or, d'argent, de palladium ou d'un de leurs alliages), déposées avant ou après gravure des motifs, ou bien, avant ou après découpe des motifs. La piste conductrice comporte, au-dessus d'au moins une partie d'au moins l'une de ces couches, une couche superficielle visible et constituée d'un alliage de rhodium déposée par électrodéposition sur la piste conductrice, la concentration en poids du rhodium dans l'alliage de rhodium étant supérieure ou égale à 50%. Au moins l'une des couches de métallisation forme une couche barrière qui permet de limiter ou d'éviter la diffusion d'éléments de l'alliage de rhodium vers les couches sous-jacentes et/ou vers la piste conductrice sous-jacente et/ou le métal de la piste conductrice (ex. du cuivre), vers les couches déposées sur celui-ci et notamment vers le cuivre.

Le rhodium confère un aspect blanc à la piste conductrice. Plus précisément, la couche superficielle de rhodium a un aspect métallique gris-blanc. Il confère à cette couche une conductivité adaptée pour une bonne connexion par contact (pression) entre celle-ci et un connecteur, par exemple un connecteur d'un dispositif de lecture/écriture de carte à puce. Cependant, sa concentration en poids doit être supérieure ou égale à 50% pour conserver les propriétés propres au rhodium et notamment une bonne résistance à la corrosion et la blancheur du dépôt.

Le circuit électrique selon l'invention comporte avantageusement l'une ou l'autre des caractéristiques suivantes considérées indépendamment les unes des autres ou en combinaison d'une ou plusieurs autres :
- l'alliage de rhodium comprend du ruthénium ;
- il comprend une couche amorce déposée sur la couche barrière, et sous la couche superficielle de l'alliage de rhodium, cette couche amorce comprenant au moins l'un des métaux, ou au moins un alliage, d'un métal compris dans la liste suivante : rhodium, ruthénium, palladium, argent et or ;
- une couche amorce a une épaisseur inférieure ou égale à 15 nanomètres ; (notamment il peut ne pas y avoir de couche amorce, si le dépôt d'une couche - par exemple d'or - sur la couche barrière sur l'autre face que celle sur laquelle est déposée l'alliage de rhodium, est réalisée rapidement avant que celle-ci ne soit trop passivée).

L'invention concerne aussi un module électronique pour carte à puce obtenu à partir du circuit électrique tel que mentionné ci-dessus, ainsi qu'un procédé de fabrication de ce circuit électrique, notamment pour la réalisation de modules de cartes à puce.

Ainsi, le module électronique comporte un circuit électrique selon l'invention, avec un substrat et au moins une piste conductrice formant une plage de contact électriquement connectée à la puce, dans lequel la piste conductrice est au moins partiellement recouverte d'une couche d'alliage de rhodium électrodéposée, la concentration en poids du rhodium dans l'alliage étant supérieure à 50%. La couche d'alliage de rhodium est électrodéposée sur une couche barrière déposée sur la piste conductrice, préalablement au dépôt par électrodéposition de la couche superficielle de l'alliage de rhodium, cette couche barrière comprenant au moins un des éléments de la liste suivante : nickel pur, alliage de nickel-phosphore et alliage de cobalt-tungstène.

Le procédé de fabrication comprend les étapes suivantes :
- fourniture d'un substrat,
- réalisation d'une couche conductrice sur le substrat, cette piste conductrice étant au moins partiellement recouverte d'une couche superficielle visible et constituée d'un alliage de rhodium, déposée par électrodéposition sur la piste conductrice, la concentration en poids du rhodium dans l'alliage de rhodium étant supérieure ou égale à 50%. La couche d'alliage de rhodium est électrodéposée sur une couche barrière déposée sur la piste conductrice, préalablement au dépôt par électrodéposition de la couche superficielle de l'alliage de rhodium, cette couche barrière comprenant au moins un des éléments de la liste suivante : nickel pur, alliage de nickel-phosphore et alliage de cobalt-tungstène.

Le procédé selon l'invention comporte avantageusement l'une ou l'autre des caractéristiques suivantes considérées indépendamment les unes des autres ou en combinaison d'une ou plusieurs autres :
- une couche amorce est déposée sur la couche barrière, préalablement au dépôt par électrodéposition de la couche superficielle de l'alliage de rhodium, cette couche amorce comprenant au moins l'un des métaux ou au moins un alliage d'un métal compris dans la liste suivante : rhodium, ruthénium, palladium, argent et or ;
- la piste conductrice comprend un ensemble de contacts réalisés par photolithogravure, la réalisation des contacts par photolithogravure ayant lieu avant le dépôt par électrodéposition de la couche superficielle de l'alliage de rhodium ;
- la piste conductrice est réalisée par co-lamination d'une grille de connexion conductrice sur le substrat.

D'autres caractéristiques et avantages de l'invention apparaîtront à la lecture de la description détaillée et des dessins annexés sur lesquels :
- La figure 1 représente schématiquement en perspective une carte à puce comportant un exemple de module selon l'invention ;
- La figure 2 représente schématiquement vue de dessus une portion de circuit électrique selon l'invention, comprenant plusieurs connecteurs pour module de carte à puce ;
- La figure 3 représente en coupe, partiellement et schématiquement, un exemple de connecteur pour un module tel que celui représenté sur la figure 1 ;
- Les figures 4a à 4k représentent schématiquement des étapes d'un exemple de mise en oeuvre du procédé selon l'invention ; et
- La figure 5 représente schématiquement un exemple d'empilement de couches que l'on peut obtenir avec le procédé selon l'invention, la nature des couches étant précisée dans le tableau ci-dessous.

Dans ce document, un exemple d'application du circuit électrique selon l'invention est pris dans le domaine de la carte à puce, mais l'homme du métier saura, sans pour cela faire preuve d'activité inventive, transposer cet exemple à d'autres applications des circuits électriques. Notamment, l'invention est particulièrement intéressante dans tous les cas où les pistes conductrices seront visibles sur le produit fini, tel qu'utilisé par le consommateur. Par exemple, la réalisation de contacts de couleur blanche pour des cartes mémoires SD ou des clés USB peut apporter une plus-value esthétique.

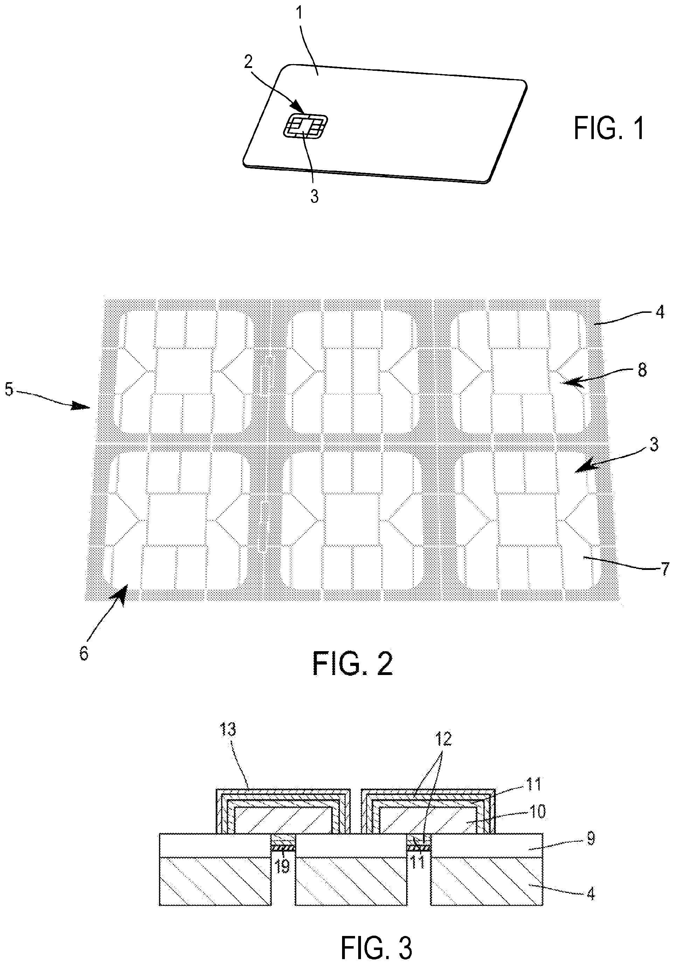

Selon un exemple d'application du circuit électrique selon l'invention, illustré par la figure 1, une carte à puce 1 comporte un module 2 avec un connecteur 3. Le module 2 est généralement réalisé sous forme d'un élément séparé qui est inséré dans une cavité ménagée dans la carte. Cet élément comporte un substrat 4 (voir Fig. 2) généralement flexible de PET, de verre-epoxy, etc. sur lequel est réalisé le connecteur 3, auquel est postérieurement connectée une puce (non-représentée), par la face du substrat opposée à celle comportant le connecteur 3.

La figure 2 illustre un exemple de portion de circuit électrique, ici un circuit imprimé 5, avec six connecteurs 3. Chaque connecteur 3 comprend une plage de contact 8 formée de pistes conductrices 6. Dans l'exemple illustré ici, huit contacts électriques 7 sont réalisés à partir des pistes conductrices 6.

Plus particulièrement, comme représenté en coupe sur la figure 3, un connecteur 3 (c'est-à-dire essentiellement un module sans puce) possède une structure multicouche formée du substrat 4, d'une couche d'adhésif 9, d'une couche de cuivre 10, d'une couche de nickel 11 (éventuellement composée en fait d'une première couche de nickel pur sur laquelle repose une deuxième couche de nickel-phosphore), d'une couche amorce optionnelle 12 et enfin d'une couche d'un alliage de rhodium 13.

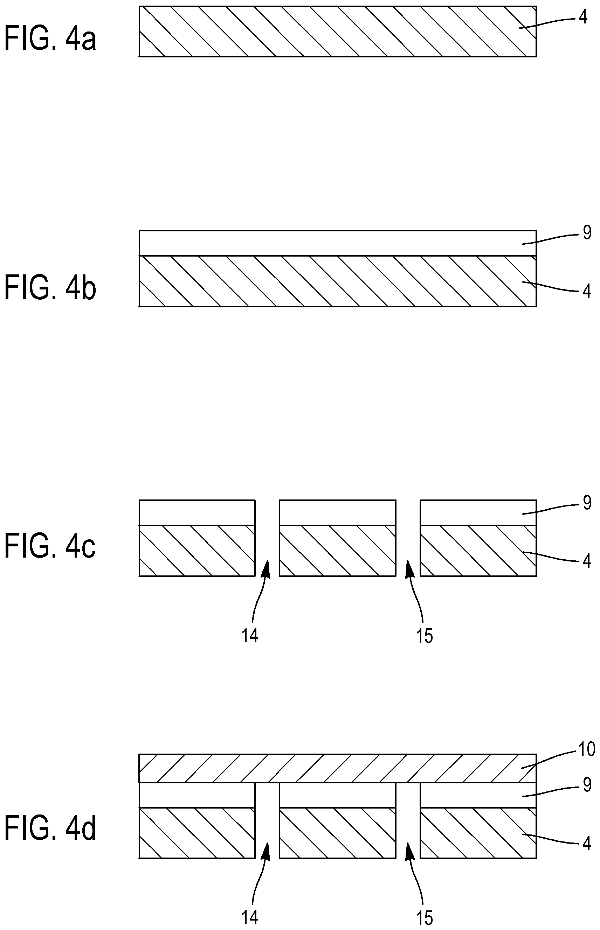

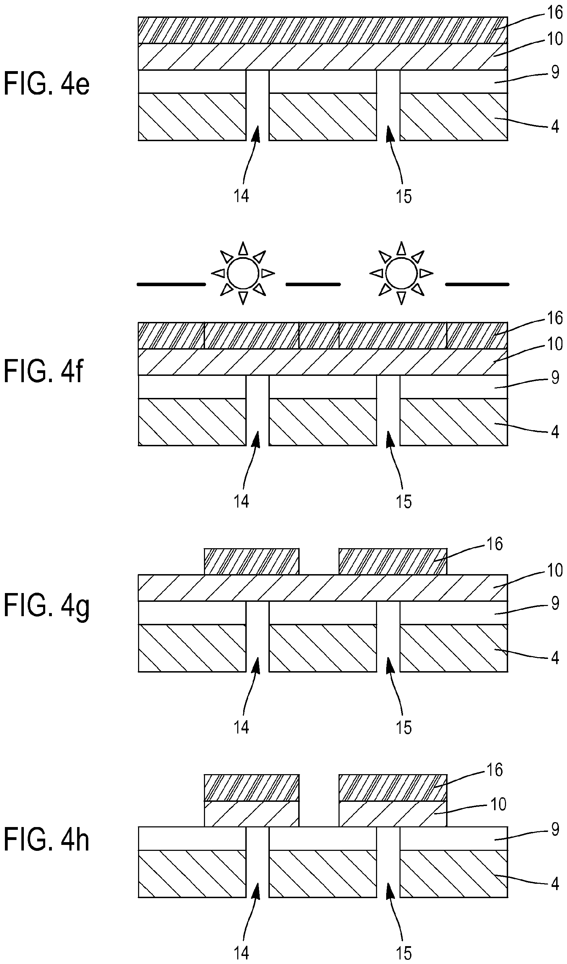

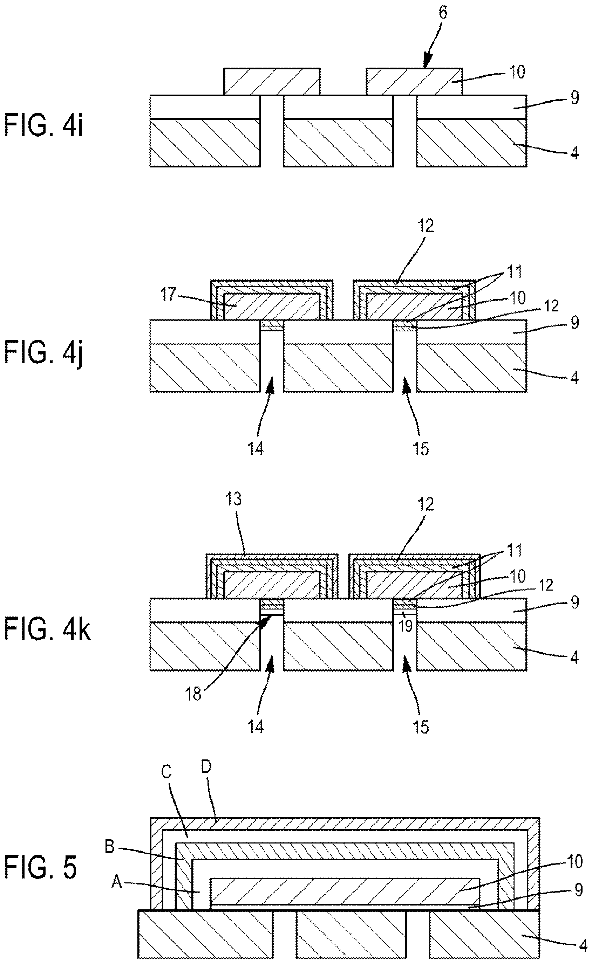

Les figures 4a à 4k illustrent schématiquement différentes étapes d'un exemple de procédé selon l'invention pour la fabrication du connecteur 3. Ces étapes comprennent :
- la fourniture d'un substrat 4 (Fig. 4a),
- l'enduction d'une face du substrat 4 avec une couche d'adhésif 9 (Fig. 4b),
- la perforation du substrat 4 muni de la couche d' adhésif 9 afin de réaliser des puits de connexion 14 et éventuellement une cavité 15 dans laquelle sera logée ultérieurement une puce (Fig. 4c),
- le complexage du substrat 4 muni de la couche d'adhésif 9 avec une couche conductrice 10 telle qu'une feuille de cuivre, d'aluminium ou autre, la réticulation à chaud de la couche d'adhésif 9 et une désoxydation du complexe ainsi obtenu (Fig. 4d),
- la lamination d'un film sec photosensible 16 (Fig. 4e) sur la couche conductrice 10,
- l'exposition du film photosensible 16 à travers un masque (Fig. 4f),
- le développement du film photosensible 16 (Fig. 4g),
- la gravure chimique de la couche de conductrice 10 dans les zones non protégées par le film photosensible 16 (Fig. 4h),
- la dissolution du film photosensible 16 (Fig. 4i),
- la métallisation des pistes de la couche conductrice 17 obtenues après gravure, en une ou plusieurs étapes pour former la couche barrière 11 de nickel (ou nickel allié), l'éventuelle couche amorce 12 (Fig. 4j), ainsi qu'une ou plusieurs éventuelles couches (par exemple nickel 11 et or 19) déposées au fond des puits de connexion 14, et
- une nouvelle métallisation pour former une couche d'alliage de rhodium 13 (Fig. 4k).

Cette dernière étape est avantageusement réalisée en protégeant, par masquage, la face arrière 18 (c'est-à-dire la face destinée à ne pas être visible sur le produit fini). Pour ce faire, un masque est appliqué sur la face du circuit électrique opposée à celle recevant les pistes conductrices 6. En effet, pour obtenir une meilleure soudabilité des fils de connexion à une puce, sur la face arrière des pistes conductrices (opposée à celle, dite « face avant » ou « face contact », qui est destinée à recevoir l'alliage de rhodium), il peut être avantageux de réaliser une métallisation sélective en appliquant un film de protection ou en plaquant une courroie de masquage ou encore en utilisant une roue de métallisation sélectrive cette face pendant l'étape de dépôt de l'alliage de rhodium. Ainsi, grâce à un masquage sélectif, on conserve la possibilité de laisser sur la face arrière de l'or en couche superficielle pour souder des fils de connexion de la puce.

La couche d'alliage de rhodium 13 est électro-déposée. Son épaisseur est comprise entre 10 nanomètres et 150 nanomètres. Cette épaisseur, ainsi que les conditions de dépôt, permettent d'obtenir un dépôt plus ou moins clair. L'alliage de rhodium est avantageusement un alliage de rhodium-ruthénium, dans lequel le rhodium représente 50% ou plus, en poids, de l'alliage. L'augmentation de la concentration de ruthénium permet de réduire le coût des solutions pour les bains électrolytiques, mais conduit à un alliage de couleur plus foncée.

La solution d'alliage de rhodium est par exemple une solution commercialisée par Metalor^{®} ou Umicore^{®}. Avantageusement, cette solution ne comprend pas d'acide sulfamique et/ou pratiquement pas (c'est-à-dire que la concentration de magnésium est dans tous les cas inférieure à 1 ppm) de magnésium (par exemple sous forme de sulfate de magnésium).

Le dépôt est réalisé à une température de 55°C +/- 10°C, avec une solution contenant 5 +8/-3 g/l de rhodium, entre 0 et 0.5 g/l de ruthénium et un pH inférieur à 1. La vitesse de métallisation est ajustée en fonction du nombre de cellules électrolytiques de métallisation utilisées pour réaliser l'épaisseur d'alliage de rhodium voulue. Les conditions de densité de courant sont également ajustées en fonction des surfaces à traiter, des épaisseurs souhaitées et de la composition de l'alliage désiré.

La couche d'alliage de rhodium obtenue avec le procédé selon l'invention a une bonne résistance à la corrosion satisfaisant aux spécifications du domaine et une résistance électrique inférieure à 500 mΩ.

Le tableau ci-dessous présente quelques exemples d'empilements de couches A à D (la couche A formant une couche barrière et les couches B et C pouvant former des couches amorces) qui peuvent être produites, sur une couche conductrice 10 telle qu'une feuille de cuivre, d'aluminium ou autre, avec le procédé selon l'invention (voir figure 5 - sur la figure 5 ne sont pas représentées les éventuelles couches métalliques déposées en face arrière) :

| | | | | | | | | | | | | | |
|---|---|---|---|---|---|---|---|---|---|---|---|---|---|
| D | | | | Rh allié | | | Rh allié | Rh allié | Rh allié | Rh allié | Rh allié | | |
| C | | | Rh allié | Pd | Rh allié | | Pd | Pd | Pd allié | Au | Au allié | Rh allié | Rh allié |
| B | | Rh allié | Au ou Ag | Au | Au ou Ag | Rh allié | Au ou Ag | Au allié | Au allié | Pd | Pd | Pd | Pd |
| A | | Ni | Ni | Ni | Ni allié | Ni allié | Ni allié | Ni allié | Ni allié | Ni | Ni allié | Ni allié | Ni |

Dans le tableau ci-dessus, le nickel peut être remplacé par un alliage de cobalt-tungstène.

Selon une variante du procédé décrit ci-dessus, en réalisant un masque avant l'étape de dépôt de l'alliage de rhodium, il est possible de réaliser des motifs, tels que des logos, de couleur gris-blanc sur fond jaune (couche d'or sous-jacente par exemple) ou gris plus foncé (couche de palladium, d'argent ou de nickel sous-jacente, par exemple). De tels motifs peuvent aussi être réalisés à des fins de personnalisation graphique ou de protection contre la copie.

## Revendications

1. Circuit électrique pour la réalisation de modules de cartes à puce, comportant un substrat (4) et au moins une piste conductrice (6), cette piste conductrice (6) est au moins partiellement recouverte d'une couche superficielle visible et constituée d'un alliage de rhodium (13), déposée par électrodéposition sur la piste conductrice (6), **caractérisé par le fait que** la couche d'alliage de rhodium (13) a une épaisseur comprise entre 10 nanomètres et 150 nanomètres, **par le fait que** la concentration en poids du rhodium dans l'alliage de rhodium est supérieure ou égale à 50% et **par le fait que** l'alliage de rhodium est déposé sur au moins une couche barrière (11) déposée sur la piste conductrice (6), préalablement au dépôt par électrodéposition de la couche superficielle de l'alliage de rhodium, cette couche barrière (11) comprenant au moins un des éléments de la liste suivante : nickel pur, alliage de nickel-phosphore et alliage de cobalt-tungstène.

2. Circuit électrique selon la revendication 1, dans lequel l'alliage de rhodium comprend du ruthénium.

3. Circuit électrique selon la revendication 1 ou 2, comprenant une couche amorce (12) déposée sur la couche barrière (11), et sous la couche superficielle de l'alliage de rhodium, cette couche amorce (12) comprenant au moins l'un des métaux, ou au moins un alliage d'un métal, compris dans la liste suivante : rhodium, ruthénium, palladium, argent et or.

4. Circuit électrique selon la revendication 3, dans lequel la couche amorce (12) a une épaisseur inférieure ou égale à 15 nanomètres.

5. Module électronique pour carte à puce, comportant un circuit électrique selon l'une des revendications précédentes, avec un substrat (4) et au moins une piste conductrice (6) formant une plage de contact (8) configurée pour être électriquement connectée à la puce, dans lequel la piste conductrice (6) est au moins partiellement recouverte d'une couche d'alliage de rhodium (13), la concentration en poids du rhodium dans l'alliage étant supérieure à 50%, cette couche d'alliage de rhodium (13) étant électrodéposée sur une couche barrière (11) déposée sur la piste conductrice (6), préalablement au dépôt par électrodéposition de la couche superficielle de l'alliage de rhodium, cette couche barrière (11) comprenant au moins un des éléments de la liste suivante : nickel pur, alliage de nickel-phosphore et alliage de cobalt-tungstène.

6. Procédé de fabrication d'un circuit électrique pour la réalisation de modules de cartes à puce, comprenant les étapes suivantes :
- fourniture d'un substrat (4),
- réalisation d'une couche conductrice (6) recouvrant au moins partiellement le substrat (4), cette piste conductrice (6) étant au moins partiellement recouverte d'une couche superficielle visible et constituée d'un alliage de rhodium (13), déposée par électrodéposition sur la piste conductrice (6),
**caractérisé par le fait que** la couche d'alliage de rhodium (13) est déposée sur une épaisseur comprise entre 10 nanomètres et 150 nanomètres, **par le fait que** la concentration en poids du rhodium dans l'alliage de rhodium est supérieure ou égale à 50% et **par le fait que** le dépôt électrolytique de la couche d'alliage de rhodium (13) est réalisé au moins en partie sur une couche barrière (11) comprenant au moins l'un des matériaux de la liste constituée du nickel pur, d'un alliage de nickel-phosphore et d'un alliage de cobalt-tungstène.

7. Procédé selon la revendication 6, dans lequel une couche amorce (12) est déposée sur la couche barrière (11), préalablement au dépôt par électrodéposition de la couche superficielle de l'alliage de rhodium, cette couche amorce (12) comprenant au moins l'un des métaux ou au moins un alliage d'un métal compris dans la liste suivante : rhodium, ruthénium, palladium, argent et or.

8. Procédé selon l'une des revendications 6 et 7, dans lequel la piste conductrice comprend un ensemble de contacts réalisés par photo-lithogravure, avant le dépôt par électrodéposition de la couche superficielle de l'alliage de rhodium.

9. Procédé selon l'une des revendications 6 et 7, dans lequel la piste conductrice est réalisée par co-lamination d'une grille de connexion conductrice sur le substrat (4).

10. Procédé selon l'une des revendications 6 à 9, dans lequel on procède à un masquage au moins partiel de la face du substrat opposée à celle au moins partiellement recouverte de la couche conductrice.

## Patentansprüche

1. Elektrische Schaltung zur Herstellung von Chipkartenmodulen, mit einem Substrat (4) und mindestens einer Leiterbahn (6), wobei diese Leiterbahn (6) mindestens teilweise mit einer sichtbaren und aus einer Rhodiumlegierung (13) bestehenden Oberflächenschicht bedeckt ist, die durch Elektroabscheidung auf der Leiterbahn (6) abgeschieden wurde, **dadurch gekennzeichnet, dass** die Schicht aus Rhodiumlegierung (13) eine Dicke zwischen 10 Nanometern und 150 Nanometern hat, dadurch, dass die Gewichtskonzentration von Rhodium in der Rhodiumlegierung 50 % oder mehr beträgt, und dadurch, dass die Rhodiumlegierung auf mindestens einer Sperrschicht (11) abgeschieden wird, die vor der galvanischen Abscheidung der Oberflächenschicht der Rhodiumlegierung auf der Leiterbahn (6) abgeschieden wird, wobei diese Sperrschicht (11) mindestens eines der Elemente aus der folgenden Liste umfasst: Reines Nickel, Nickel-Phosphor-Legierung und Kobalt-Wolfram-Legierung.

2. Elektrischer Schaltkreis nach Anspruch 1, wobei die Rhodiumlegierung Ruthenium umfasst.

3. Elektrische Schaltung nach Anspruch 1 oder 2, die eine auf der Sperrschicht (11) und unter der Oberflächenschicht der Rhodiumlegierung abgeschiedene Primerschicht (12) umfasst, wobei die Primerschicht (12) mindestens eines der Metalle oder mindestens eine Legierung eines Metalls aus der folgenden Liste umfasst: Rhodium, Ruthenium, Palladium, Silber und Gold.

4. Elektrische Schaltung nach Anspruch 3, wobei die Primerschicht (12) eine Dicke von 15 Nanometern oder weniger hat.

5. Elektronisches Modul für eine Chipkarte, mit einer elektrischen Schaltung nach einem der vorhergehenden Ansprüche, mit einem Substrat (4) und mindestens einer Leiterbahn (6), die eine Kontaktfläche (8) bildet, die so gestaltet ist, dass sie elektrisch mit dem Chip verbunden werden kann, wobei die Leiterbahn (6) zumindest teilweise mit einer Schicht aus einer Rhodiumlegierung (13) bedeckt ist, die Gewichtskonzentration des Rhodiums in der Legierung größer als 50 % ist, wobei diese Rhodiumlegierungsschicht (13) auf einer auf der Leiterbahn (6) abgeschiedenen Barriereschicht (11) vor der galvanischen Abscheidung der Oberflächenschicht der Rhodiumlegierung galvanisch abgeschieden wird, wobei diese Barriereschicht (11) mindestens eines der Elemente aus der folgenden Liste umfasst: Reines Nickel, Nickel-Phosphor-Legierung und Kobalt-Wolfram-Legierung.

6. Verfahren zur Herstellung eines elektrischen Schaltkreises für die Realisierung von Smartcard-Modulen, das die folgenden Schritte umfasst:
- Bereitstellung eines Substrats (4),
- Herstellung einer leitenden Schicht (6), die das Substrat (4) zumindest teilweise bedeckt, wobei diese Leiterbahn (6) zumindest teilweise mit einer sichtbaren Oberflächenschicht bedeckt ist und aus einer Rhodiumlegierung (13) besteht, die durch Elektroabscheidung auf der Leiterbahn (6) abgeschieden wird,
**dadurch gekennzeichnet, dass** die Rhodiumlegierungsschicht (13) in einer Dicke zwischen 10 Nanometern und 150 Nanometern abgeschieden wird, dadurch, dass die Gewichtskonzentration von Rhodium in der Rhodiumlegierung 50 % oder mehr beträgt, und dadurch, dass die elektrolytische Abscheidung der Rhodiumlegierungsschicht (13) zumindest teilweise auf einer Barriereschicht (11) erfolgt, die mindestens eines der Materialien aus der Liste umfasst, die aus reinem Nickel, einer Nickel-Phosphor-Legierung und einer Kobalt-Wolfram-Legierung besteht.

7. Verfahren nach Anspruch 6, bei dem vor der galvanischen Abscheidung der Oberflächenschicht der Rhodiumlegierung eine Primerschicht (12) auf der Barriereschicht (11) abgeschieden wird, wobei die Primerschicht (12) mindestens eines der Metalle oder mindestens eine Legierung eines Metalls aus der folgenden Liste umfasst: Rhodium, Ruthenium, Palladium, Silber und Gold.

8. Verfahren nach einem der Ansprüche 6 oder 7, bei dem die Leiterbahn eine Reihe von Kontakten umfasst, die vor der galvanischen Abscheidung der Oberflächenschicht der Rhodiumlegierung durch Fotolithographie hergestellt wurden.

9. Verfahren nach einem der Ansprüche 6 oder 7, wobei die Leiterbahn durch Co-Laminieren eines leitfähigen Leiterrahmens auf dem Substrat (4) hergestellt wird.

10. Verfahren nach einem der Ansprüche 6 bis 9, bei dem eine zumindest teilweise Maskierung der Seite des Substrats vorgenommen wird, die der Seite gegenüberliegt, die zumindest teilweise mit der leitfähigen Schicht bedeckt ist.

## Claims

1. Electrical circuit for producing chip card modules, comprising a substrate (4) and at least one conductive track (6), this conductive track (6) being at least partially covered with a visible surface layer consisting of a rhodium alloy (13), deposited by electrodeposition on the conductive track (6), **characterized in that** the rhodium alloy layer (13) has a thickness of between 10 nanometres and 150 nanometres, by the fact that the concentration by weight of rhodium in the rhodium alloy is greater than or equal to 50% and by the fact that the rhodium alloy is deposited on at least one barrier layer (11) deposited on the conductive track (6), prior to the deposition by electrodeposition of the surface layer of the rhodium alloy, this barrier layer (11) comprising at least one of the elements from the following list: pure nickel, nickel-phosphorus alloy and cobalt-tungsten alloy.

2. The electrical circuit of claim 1, wherein the rhodium alloy comprises ruthenium.

3. Electrical circuit according to claim 1 or 2, comprising a primer layer (12) deposited on the barrier layer (11) and under the surface layer of the rhodium alloy, this primer layer (12) comprising at least one of the metals, or at least one alloy of a metal, included in the following list: rhodium, ruthenium, palladium, silver and gold.

4. An electrical circuit as claimed in claim 3, wherein the seed layer (12) is less than or equal to 15 nanometres thick.

5. Electronic module for a chip card, comprising an electrical circuit according to one of the preceding claims, with a substrate (4) and at least one conductive track (6) forming a contact pad (8) configured to be electrically connected to the chip, in which the conductive track (6) is at least partially covered with a rhodium alloy layer (13), the concentration by weight of rhodium in the alloy being greater than 50%, this rhodium alloy layer (13) being electrodeposited on a barrier layer (11) deposited on the conductive track (6), prior to the electrodeposition of the surface layer of the rhodium alloy, this barrier layer (11) comprising at least one of the elements from the following list: pure nickel, nickel-phosphorus alloy and cobalt-tungsten alloy.

6. A method of manufacturing an electrical circuit for producing chip card modules, comprising the following steps:
- supply of a substrate (4),
- production of a conductive track (6) at least partially covering the substrate (4), this conductive track (6) being at least partially covered by a visible surface layer consisting of a rhodium alloy (13), deposited by electrodeposition on the conductive track (6),
**characterized in that** the rhodium alloy layer (13) is deposited to a thickness of between 10 nanometres and 150 nanometres, by the fact that the concentration by weight of rhodium in the rhodium alloy is greater than or equal to 50% and by the fact that the electrodeposition of the rhodium alloy layer (13) is carried out at least in part on a barrier layer (11) comprising at least one of the materials from the list consisting of pure nickel, a nickel-phosphorus alloy and a cobalt-tungsten alloy.

7. Process according to claim 6, in which a primer layer (12) is deposited on the barrier layer (11), prior to the electrodeposition of the surface layer of the rhodium alloy, this primer layer (12) comprising at least one of the metals or at least one alloy of a metal included in the following list: rhodium, ruthenium, palladium, silver and gold.

8. A process according to one of claims 6 and 7, in which the conductive track comprises a set of contacts made by photo-lithography, prior to the electrodeposition of the surface layer of the rhodium alloy.

9. Process according to one of claims 6 and 7, in which the conductive track is produced by co-lamination of a conductive connection grid on the substrate (4).

10. Process according to one of claims 6 to 9, in which the face of the substrate opposite that at least partially covered by the conductive layer is at least partially masked.
